# EUROPÄISCHE PATENTSCHRIFT

(11) **EP 3 577 662 B1**
(45) Veröffentlichungstag und Bekanntmachung des Hinweises auf die Patenterteilung: **17.08.2022**
(21) Anmeldenummer: 17821609.9
(22) Anmeldetag: 19.12.2017
(51) Int. Cl.: H01C 1/14, H01C 7/02, H05B 3/03, H05B 3/14, H05K 1/02

(54) **PTC-HEIZER MIT VERRINGERTEM EINSCHALTSTROM**
PTC HEATER WITH REDUCED SWITCH-ON CURRENT
ÉLÉMENT CHAUFFANT À COEFFICIENT DE TEMPÉRATURE POSITIF (CTP) À COURANT D'APPEL RÉDUIT

(30) Priorität: 01.02.2017 DE 102017101946
(43) Veröffentlichungstag der Anmeldung: 11.12.2019
(73) Patentinhaber: TDK Electronics AG, 81671 München (DE)
(72) Erfinder: STEINBERGER, Bernhard, 8511 Sankt Stefan ob Stainz (AT); BREZINA, Jirí, 78961 Bludov (CZ); GEPRT, Michal, 78961 Bludov (CZ); SITA, Zdenek, 56301 Lanskroun (CZ)
(74) Vertreter: Epping - Hermann - Fischer
(86) Internationale Anmeldenummer: PCT/EP2017/083598
(87) Internationale Veröffentlichungsnummer: WO 2018/141458

(56) Entgegenhaltungen:
- EP-A1- 0 781 889
- EP-A1- 1 657 963
- EP-A2- 0 437 239
- DE-A1- 1 639 354
- DE-A1-102015 107 322
- GB-A- 1 222 887

## Beschreibung

Die Erfindung betrifft PTC-Heizer, bei denen der Einschaltstrom verringert ist.

PTC-Heizer haben ein Wandelelement aus einem PTC-Material (PTC = Positive Temperature Coefficient = positiver Temperaturkoeffizient), d. h. der elektrische Widerstand des PTC-Materials nimmt mit steigender Temperatur zu. Solche Heizer können zur Umwandlung elektrischer Energie in Wärmeenergie dienen.

Bei bekannten PTC-Heizern ist das PTC-Material in einer relativ dünnen Schicht enthalten. Die dünne Schicht ist zwischen zwei Elektroden angeordnet. Ein elektrischer Strom, der von einer Elektrode durch das PTC-Material zur anderen Elektrode fließt, deponiert Energie im PTC-Material, die in Wärme umgewandelt wird. Typischerweise ist dabei zumindest eine der Elektroden gleichzeitig ein Koppelelement, mit dem das PTC-Material thermisch an seine Umgebung gekoppelt ist. Diese Elektrode dient somit zur Abführung der entstandenen Wärme an die Umgebung. Der Abstand zwischen den Elektroden ist dabei möglichst gering, sodass bei einem vorgegebenen Volumen an PTC-Material die Oberfläche der Elektrode und damit die Oberfläche, über die Energie an die Umgebung abgegeben wird, relativ groß ist. Durch die geringe Dicke des PTC-Materials ist der thermische Widerstand des Heizers gering.

Allerdings zeichnen sich solcher PTC-Heizer durch einen relativ hohen Einschaltstrom und damit einhergehend durch eine relativ geringe Durchbruchspannung aus. Diese elektrischen Parameter sind zudem sehr stark von Schwankungen der Prozesse während der Herstellung des Heizers abhängig. Entsprechend muss ein relativ hoher Herstellungsaufwand betrieben werden, um die Ausschussrate beim Herstellen der Heizer möglichst gering zu halten.

Aus der EP 0437239 A2 sind Verfahren zur Herstellung eines organischen PTC-Materials bekannt.

Aus der DE 102015107322 A1 sind Heizwiderstände, z.B. mit PTC Keramik, bekannt.

Aus der EP 1657963 A1 sind Heizer, z. B. mit PTC-Elementen, für Platinen bekannt.

Aus der DE 1639354 A1 sind PTC-Heizelemente mit Siliziumkarbid bekannt.

Aus der EP 0 781 889 A1 sind Heizer, z. B. mit Bariumtitanat als PTC Keramik , bekannt.

Es besteht deshalb der Wunsch nach PTC-Heizern, bei denen der Einschaltstrom verringert ist, die Durchbruchspannung erhöht ist und die Abhängigkeit der Qualität der Heizer von Schwankungen von Parametern während der Herstellung verringert ist. Ein entsprechend verbesserter PTC-Heizer ist dem unabhängigen Anspruch 1 zu entnehmen. Abhängige Ansprüche geben vorteilhafte Ausgestaltungen an.

Der PTC-Heizer hat einen Grundkörper mit einer Länge L, einer Breite B und einer Höhe H. Der Grundkörper besteht aus einem PTC-Material, d. h. aus einem Material mit einem positiven Temperaturkoeffizienten. Der spezifische Widerstand des PTC-Materials nimmt mit steigender Temperatur zu. Ferner hat der PTC-Heizer eine erste Elektrode und eine zweite Elektrode.

Die beiden Elektroden bestehen aus einem elektrisch leitenden Material. Für die Länge, die Breite und die Höhe gilt: L ≥ B ≥ H. Das heißt, bezogen auf einen Grundkörper mit einer bestimmten Form sind die Richtungen, in denen Länge, Breite und Höhe gemessen werden, so zueinander ausgerichtet, dass die Breite ≥ der Höhe ist. Die Länge ist ≥ der Breite. Die Länge ist dabei der größtmögliche Abstand zweier Punkte des Grundkörpers. Die Elektroden sind so am Grundkörper befestigt, dass für ihren Abstand d gilt: d > H.

Das heißt, es wird ein PTC-Heizer angegeben, bei dem die Elektroden einen Abstand voneinander haben, der größer ist als die Höhe des Heizers. Von den drei Abmessungen Länge, Breite, Höhe hat die Höhe den geringsten Wert. Bezogen auf einen flachen Grundkörper stellt die Höhe des Grundkörpers somit im Wesentlichen seine Dicke dar. Dass der Abstand der Elektroden sich von der Dicke des Grundkörpers unterscheidet, ist somit gleichbedeutend mit der Tatsache, dass die Elektroden gerade nicht auf den gegenüberliegenden "großflächig flachen" Seiten des Heizers angeordnet sind.

Während bei bekannten PTC-Heizern die Form des Grundkörpers und die Position der Elektroden so gewählt sind, dass der elektrische Strom einen möglichst geringen Weg durch den Grundkörper zurücklegt, so ist nun gefordert, dass die Elektroden so angeordnet sind, dass der elektrische Strom einen weiteren Weg zurücklegt. Das PTC-Material des PTC-Heizers kann ein Varistor-Material mit einem signifikanten Varistoreffekt sein. Dann hängt der spezifische Widerstand von der angelegten Spannung ab. Solche Materialien können auch in konventionellen PTC-Heizern Verwendung finden. In solchen Materialien können gesinterte Keramikzusammensetzungen enthalten sein. Der elektrische Gesamtwiderstand des PTC-Materials entspricht der Summe aus dem Widerstand, der dem Volumen der gesinterten Zusammensetzung zuzuordnen ist und dem Anteil des Widerstands, der auf die Korngrenzen der gesinterten keramischen Zusammensetzung zuzuordnen ist. An den Korngrenzen bilden sich elektrische Potenzialbarrieren aus, die die Ladungsträger des Stroms, z. B. freie Elektronen, davon abhalten, in benachbarte Bereiche zu diffundieren. Für PTC-Heizer mit relativ hoher Betriebsspannung müssen diese Potenzialbarrieren entsprechend hoch ausgebildet sein. Dadurch steigt der Anteil des gesamten Widerstands, der auf die Korngrenzen zurückzuführen ist. Derartige PTC-Heizer haben eine deutlich ausgeprägte Abhängigkeit des Widerstands von der angelegten Spannung. Wenn nun eine hohe Betriebsspannung - insbesondere beim Einschaltvorgang - angelegt wird, so nimmt die Höhe der Potenzialbarriere aufgrund des Varistoreffekts ab und der Widerstand des Heizers verringert sich deutlich. Gleichzeitig ist die Temperatur des Heizers noch relativ gering. Infolgedessen ist der Einschaltstrom sehr hoch. Ein hoher Einschaltstrom hat negative Auswirkungen auf elektrische oder elektronische Schaltungskomponenten in der Schaltungsumgebung des Heizers.

Nichtlineares Verhalten nimmt mit zunehmender Spannung bzw. zunehmender elektrischer Feldstärke zu. Durch eine Vergrößerung des Abstands der Elektroden und damit einhergehend durch eine Verringerung der elektrischen Feldstärke im Innern des Varistormaterials bei konstanter Spannung sind nichtlineare Effekte verringert. Im Gegensatz zu konventionellen PTC-Heizern werden Fluktuationen des Widerstands durch die Verlegung der Position der Elektroden verringert. Schwankungen der Gesamtleitfähigkeit des Bauelements sind entsprechend verringert. Entsprechend sind die Abhängigkeit des Widerstands des PTC-Materials von Fluktuationen oder Variationen während der Herstellung einerseits und damit der Ausschuss an PTC-Heizern, die geforderten Spezifikationen nicht genügen andererseits verringert.

Dadurch, dass die Elektroden des Heizers nicht auf den nahe beieinanderliegenden großen Oberflächen eines flächig gebildeten Grundkörpers liegen, sondern die Elektroden an den weiter entfernten Enden des Grundkörpers liegen, ist der Einschaltstrom verringert, insbesondere wenn derselbe Gesamtwiderstand des Heizers beibehalten wird. Die Durchbruchspannung ist erhöht und die Empfindlichkeit gegenüber Schwankungen bei der Herstellung ist verringert. Dazu trägt auch bei, dass bei vorgegebener elektrischer Spannung die Stärke des elektrischen Felds reziprok zum Abstand der Elektroden ist. Das elektrische Feld im Material des PTC-Heizers ist verringert, was nicht lineare Effekte, z. B. an Korngrenzen, ebenfalls verringert.

Es ist möglich, dass für die Länge, die Breite und die Höhe gilt: L ≥ B > H, d. h. die Breite ist tatsächlich größer als die Höhe.

Es ist möglich, dass der Grundkörper die Form eines Quaders, eines Zylinders, einer Folie oder eines Ellipsoids hat. Hat der Grundkörper die Form eines Quaders, z. B. eines sehr flachen Quaders, so können die gegenüberliegenden Flächen mit dem kleinsten Abstand durchaus zum Abführen der Wärme verwendet werden. Allerdings sind diese Seitenflächen des Quaders gerade nicht diejenigen, über die der Strom im Wesentlichen zugeführt wird.

Der Grundkörper kann sogar so flach ausgestaltet sein, dass er praktisch eine Folie darstellt. Der Strom fließt dabei jedoch nicht entlang der Dickenrichtung durch die Folie, sondern quasi von einem Ende der Folie zu einem anderen Ende, aber nicht von einer Seite der Folie zur anderen, dicht benachbarten Seite der Folie.

Die Erfindung sieht vor, dass der Grundkörper dotiertes BaTiO₃ (Bariumtitanat) umfasst. Bariumtitanat stellt dabei das Ausgangsmaterial des PTC-Materials des Heizers dar. Das Bariumtitanat umfasst zusätzliche Elemente wie Strontium, Blei und/oder Kalzium.

Durch Hinzufügen von Strontium kann die Curietemperatur des Materials verringert sein. Durch Hinzugabe von Blei kann die Curietemperatur erhöht sein.

Erfindungsgemäß ist das Ausgangsmaterial des PTC-Materials durch Zugabe seltener Erden, z. B. Scandium, Yttrium, Lanthan, Cer, Praseodym, Neodym, Promethium, Samarium, Europium, Gadolinium, Terbium, Dysprosium, Holmium, Erbium, Thulium, Ytterbium und/oder Lutetium einerseits und/oder durch Zugabe von Mangan, Eisen oder Aluminium andererseits optimiert . Durch Zugabe dieser Elemente kann der Ausgangswiderstand bei Raumtemperatur eingestellt sein.

Es ist möglich, dass die Länge des PTC-Heizers und/oder des Grundkörpers 2,5 cm oder oder 3,5 cm oder mehr ist. Die maximale Länge kann bei 5 cm oder weniger liegen. Der PTC-Heizer oder der Grundkörper kann eine Breite von 1 cm oder mehr und eine Breite von 4 cm oder weniger aufweisen. Die Höhe kann 100 µm oder mehr betragen. Höhen von 4 mm oder 5 mm sind möglich.

Es ist möglich, dass der PTC-Heizer einen Träger aufweist. Der Grundkörper ist auf dem Träger angeordnet.

Insbesondere wenn der Grundkörper als dünne Folie ausgeführt ist, dient der Träger dazu, dem PTC-Heizer eine stabile Form zu geben. Im Übrigen kann der Träger auch helfen, im Grundkörper dissipierte Energie an die Umgebung abzugeben.

Die Erfindung sieht vor, dass die Elektroden Chrom, Nickel, Titan, Aluminium, Silber, Kupfer und/oder Gold umfassen.

Es ist bevorzugt, dass die Elektroden einen möglichst geringen elektrischen Widerstand aufweisen.

Die Elektroden können als Klemmelektroden ausgestaltet und an den Grundkörper an den entsprechenden Enden angeklemmt sein.

Die Erfindung sieht vor, dass der Grundkörper an einer oder mehreren Seitenflächen eine dielektrische Schicht aufweist.

Die dielektrische Schicht ist elektrisch isolierend und aufgrund der von konventionellen Heizern abweichenden Gestaltung nötig, wenn dissipierte Wärme über die großflächigen Seitenflächen, an denen bei konventionellen Heizern die Elektroden angebracht sind, abgegeben werden soll.

Die dielektrische Schicht kann eine oxidische Keramik, z. B. auf der Basis von einem Alumimiumoxid, z. B. Al₂O₃, Chromoxiden oder Nickeloxiden, aufweisen.

Der PTC-Heizer kann einen Kühlkörper aufweisen. Der Kühlkörper kann mit dem Grundkörper verbunden sein. Der Kühlkörper ist dazu vorgesehen, im Grundkörper dissipierte Wärme an die Umgebung abzugeben.

Bei konventionellen PTC-Heizern ist das PTC-Material dasjenige Element, was einen direkten Kurzschluss zwischen den Elektroden verhindert. Ladungsträger auf ihrem Weg von einer Elektrode zur anderen Elektrode müssen den - dünnen - Grundkörper durchdringen und deponieren dabei Energie im Grundkörper.

Befinden sich die Elektroden nun an den längsseitigen Enden des Grundkörpers und sind an den Flanken des Grundkörpers ein oder mehrere Kühlkörper aus Metall angeordnet, so kann ein Kühlkörper einen für Ladungsträger bevorzugten Strompfad von einer Elektrode zur anderen Elektrode darstellen, selbst wenn die Kühlkörper nicht direkt mit den Elektroden verbunden sind. Elektrischer Strom würde dann in einem ersten Abschnitt von einer Elektrode durch einen Teil des Grundkörpers in ein Ende des Kühlkörpers fließen. Der Strom passiert dann den Kühlkörper, aber nicht den langen Weg im PTC-Material. Am anderen Ende des Kühlkörpers würde der Strom dann über ein letztes Segment des Grundkörpers zur zweiten Elektrode flie-ßen.

Damit dies nicht geschieht, dient die dielektrische Schicht als Isolationsschicht dazu, den Kühlkörper galvanisch von den Elektroden und von dem mit den Elektroden verschalteten Grundkörper zu trennen.

Zentrale Merkmale des vorliegenden PTC-Heizers, Funktionsprinzipien und Details einiger nicht einschränkender Ausführungsbeispiele sind in den schematischen Figuren näher erläutert.

Es zeigen:
- Fig. 1:: eine perspektivische Ansicht eines Heizers,
- Fig. 2:: die Bedeutung der Begriffe Länge, Breite, Höher,
- Fig. 3:: eine alternative Möglichkeit, die Elektroden anzuordnen,
- Fig. 4:: bekannte Heizer mit kurzem Strompfad,
- Fig. 5:: einen Querschnitt durch einen Heizer,
- Fig. 6:: einen Querschnitt durch einen Heizer mit einer alternativen Elektrodenform,
- Fig. 7:: einen Querschnitt durch einen Heizer mit einer Isolationsschicht,
- Fig. 8:: einen Querschnitt durch einen Heizer mit zwei Isolationsschichten,
- Fig. 9:: die Möglichkeit, Elektroden auf derselben Fläche des Grundkörpers anzuordnen,
- Fig. 10:: die Möglichkeit, einen Kühlkörper für eine verbesserte Wärmeabgabe vorzusehen,
- Fig. 11:: die Möglichkeit, den Grundkörper auf einem Träger anzuordnen.

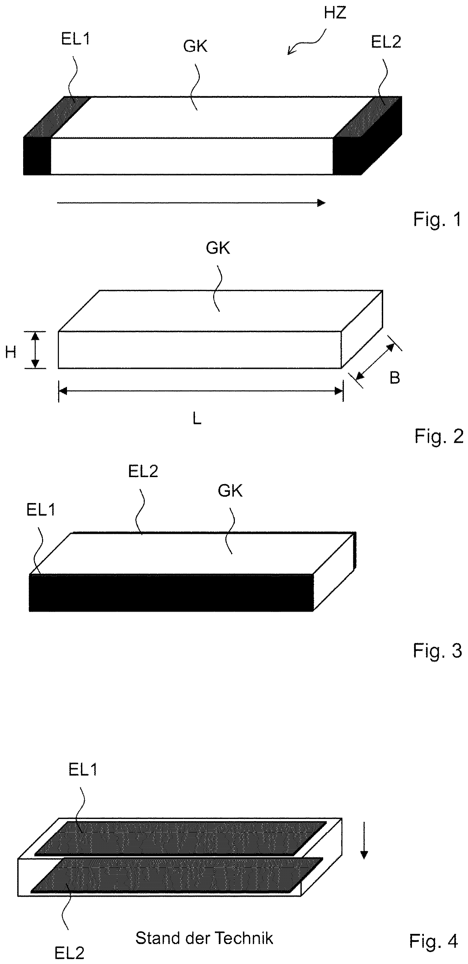

Figur 1 zeigt eine grundlegende Ausgestaltung, bei der der Heizer HZ einen Grundkörper GK aufweist, der zwischen einer ersten Elektrode EL1 und einer zweiten Elektrode EL2 angeordnet ist. Der Pfeil gibt dabei eine mögliche Richtung des elektrischen Stroms an. Der Grundkörper GK hat in Figur 1 beispielhaft die Form eines Quaders. Die Elektroden sind dabei an Enden des Grundkörpers angeordnet, die nicht den kleinsten Abstand haben. Der Weg des elektrischen Stroms ist deshalb relativ groß. Dadurch ist die elektrische Feldstärke im Grundkörper verringert und die Zahl der Korngrenzen, die elektrischer Strom überwinden muss, erhöht.

Figur 2 zeigt die Bedeutung der Begriffe Länge, Breite und Höhe bezogen auf einen Grundkörper. Die Länge ist dabei im Wesentlichen der größtmögliche Abstand gegenüberliegender Enden, Abschnitte oder Flächen des Grundkörpers GK. Die Höhe ist ein Maß für den kleinstmöglichen Abstand gegenüberliegender Flächen, Seiten, Enden oder Abschnitte des Grundkörpers.

Die Form des Grundkörpers ist nicht auf Quader oder quaderähnliche Formen beschränkt. Alle möglichen Formen, denen sich eine Länge, eine Breite und eine Höhe entsprechend der Relation L ≥ B ≥ H zuordnen lassen, sind möglich.

Figur 3 zeigt die Möglichkeit, die beiden Elektroden so anzuordnen, dass der Grundkörper dazwischen angeordnet ist, ohne dass die Elektroden den größtmöglichen Abstand voneinander haben. Allerdings ist darauf zu achten, dass die Elektroden gerade nicht den kleinstmöglichen Abstand voneinander haben, um die oben genannten Nachteile bekannter PTC-Heizer zu vermeiden.

Figur 4 zeigt gerade die typische Geometrie eines üblichen PTC-Heizers. Die Elektroden EL1, EL2 sind relativ zum dazwischenliegenden Grundkörper so angeordnet, dass der Weg, den der elektrische Strom nehmen muss (Pfeil), möglichst gering ist. In diesem Fall können nämlich die Elektroden selbst möglichst großflächig ausgestaltet sein und gleichzeitig als Wärmebrücke für eine gut funktionierende Wärmeabfuhr an die Umgebung dienen.

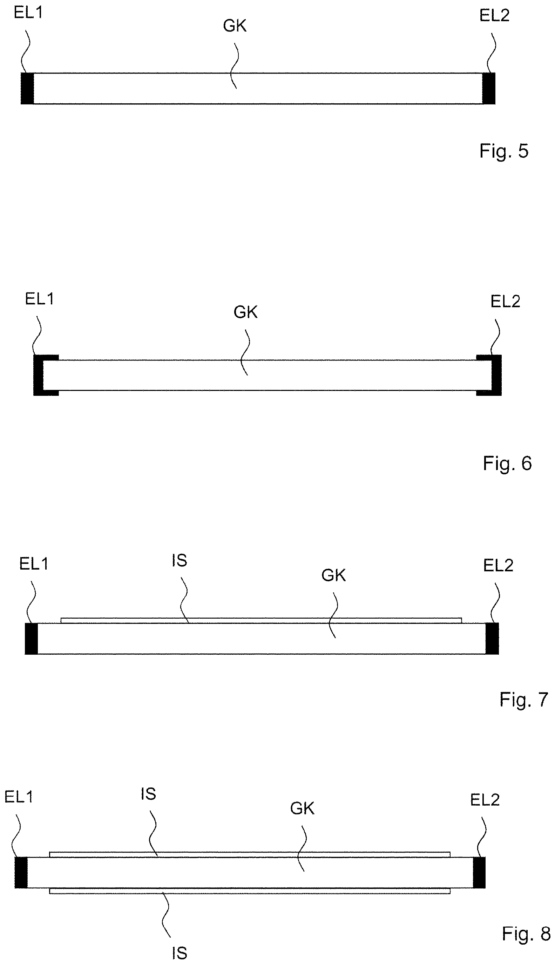

Figur 5 zeigt eine mögliche Form der Elektroden EL1, EL2. Das Material der Elektroden bedeckt dabei die voneinander weg weisenden Seitenflächen gegenüberliegender Enden des Grundkörpers GK.

Figur 6 zeigt eine alternative Ausführungsform der Form der Elektroden. Diese sind nicht auf die gegenüberliegenden Stirnflächen beschränkt. Vielmehr reichen die Elektroden auch noch ein gewisses Maß über die Kanten zu den anliegenden Seitenflächen der jeweiligen Elektrode hinaus. Sind die Elektroden als Klemm-Elektroden ausgeführt, so lassen sie sich relativ leicht am Material des Grundkörpers GK befestigen und haben dabei einen relativ stabilen mechanischen Kontakt. Entsprechend niedrig ist auch der elektrische Widerstand beim Übergang vom Material der Elektroden zum Material des Grundkörpers.

Figur 7 zeigt die Möglichkeit, eine dielektrische Schicht als Isolation IS auf zumindest einer Seite des Grundkörpers anzuordnen.

In Figur 8 ist gezeigt, dass beide gegenüberliegenden Flächen mit einem möglichst kleinen Abstand voneinander von einer eigenen Isolationsschicht IS bedeckt sein können. Der Weg von einem Punkt im Grundkörper GK zur Umgebung des Grundkörpers führt dabei häufig über die Seitenfläche, auf der die Isolationsschichten angeordnet sind, da diese Seiten gerade diejenigen Seiten sind, die aufgrund der geringen Dicke großflächig ausgebildet sind. Entsprechend lassen sich diese Flächen gut nutzen, um dissipierte Wärme abzuführen.

Damit der elektrische Strom von einer Elektrode zur anderen Elektrode auch tatsächlich den Weg durch den Grundkörper GK nimmt und nicht einen Weg eines geringeren elektrischen Widerstands über eine Umgebung des Grundkörpers GK nimmt, ist der Grundkörper GK zumindest an den kritischen Bereichen durch die dielektrische Schicht isoliert.

Ob eine Isolationsschicht nun nur auf einer Seite des Grundkörpers (wie in Figur 7 gezeigt) oder auf zwei Seiten des Grundkörpers (wie in Figur 8 gezeigt) angeordnet ist, kann dabei von der äußeren Umgebung des Grundkörpers und/oder des PTC-Heizers abhängen.

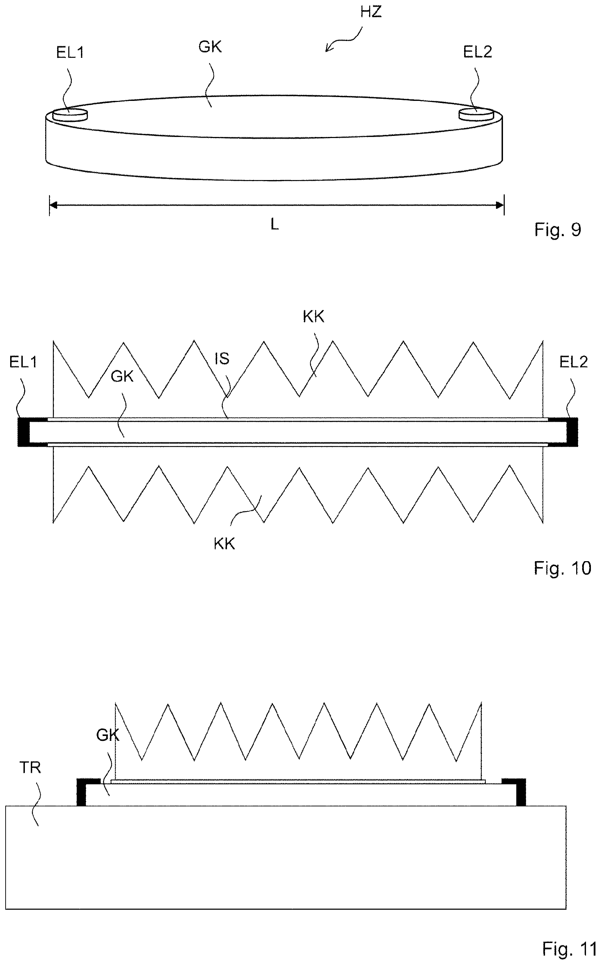

Figur 9 zeigt exemplarisch und in einer perspektivischen Ansicht, dass die Form des Grundkörpers nicht auf Quader beschränkt ist. Zylinder mit einer geringen Höhe, also runde Platten, aber auch andere Formen wie Platten mit ovalem Grundrisse, können Verwendung finden.

Im Übrigen zeigt Figur 9 zusätzlich, dass die Elektroden an den entfernten Enden des Grundkörpers angeordnet sein sollen. Da es auf die Entfernung von Elektroden, aber nicht auf die Seite des Grundkörpers ankommt, können auch beide Elektroden auf derselben Seite des Grundkörpers angeordnet sein, um in die oben genannten Vorteile des vorgestellten PTC-Heizers zu kommen.

Figur 10 zeigt die Möglichkeit, einen Kühlkörper KK in thermischen Kontakt mit dem Grundkörper GK zu bringen. Damit elektrischer Strom zwischen den Elektroden nicht über den Kühlkörper KK fließt, ist dieser vorzugsweise durch eine dielektrische Isolationsschicht IS galvanisch von dem elektrischen System getrennt. Kühlkörper und Isolationsschicht können dabei auf einer, aber auch auf beiden großflächig ausgebildeten Seiten des PTC-Heizers angeordnet sein. Der Kühlkörper weist vorzugsweise eine große Oberfläche, z. B. mittels Kühlrippen, auf, um den Widerstand des Wärmeflusses gering zu halten.

Figur 11 zeigt die Möglichkeit, den Grundkörper auf einem Träger TR anzuordnen.

Die beschriebene Konfiguration des Grundkörpers ermöglicht es, den Grundkörper als dünne Folie auszugestalten. Damit auch bei dünnen Folien eine ausreichende mechanische Stabilität erhalten wird, kann die Folie auf dem Träger TR angeordnet und mit ihm verbunden sein. Über den Träger TR einerseits, aber auch über einen Kühlkörper andererseits kann Wärme an die Umgebung abgegeben werden.

Im Träger TR oder in einem Kühlkörper KK können zusätzlich Hohlräume angeordnet sein, in denen eine Flüssigkeit mit hoher spezifischer Wärmekapazität, z. B. Kühlwasser, fließen kann, um die Wärmeabgabe zu verbessern und einen höheren thermischen Leistungsbereich zu erschließen.

Der thermische Leistungsbereich kann dabei zwischen einigen wenigen Watt, z. B. 2 W, und einigen hundert Watt, z. B. 300 W, liegen.

Eine typische elektrische Leistung beträgt dabei etwa 50 W, 100 W, 150 W oder 200 W.

Entsprechende PTC-Heizer weisen einen Wirkungsgrad von nahezu 100 % auf.

Der PTC-Heizer ist nicht auf die genannten Merkmale oder die gezeigten Ausführungsbeispiele beschränkt. Ein Heizer kann zusätzliche Schaltungselemente, Fühler, thermische Koppelelemente oder dergleichen aufweisen.

### Bezugszeichenliste

- B:: Breite
- EL1, EL2:: Elektroden
- GK:: Grundkörper
- H:: Höhe
- HZ:: PTC-Heizer
- IS:: dielektrische Isolationsschicht
- KK:: Kühlkörper
- L:: Länge
- TR:: Träger

## Patentansprüche

1. PTC-Heizer (HZ) mit verringertem Einschaltstrom, aufweisend
- einen Grundkörper (GK) mit einer Länge L, einer Breite B und einer Höhe H aus einem PTC-Material,
- eine erste Elektrode (EL1) und eine zweite Elektrode (EL2) aus einem elektrisch leitenden Material,
eine dielektrische Schicht (IS) an einer Seitenfläche des Grundkörpers (GK),
wobei
- für L, B und H gilt: L ≥ B ≥ H,
- die Elektroden (EL1, EL2) so an dem Grundkörper (GK) befestigt sind, dass für ihren Abstand voneinander d gilt: d > H;
- der Grundkörper (GK) dotiertes BaTiO₃ umfasst, und
- der Grundkörper (GK) Sr, Pb und/oder Ca umfasst, und
- der Grundkörper (GK) ein Element der seltenen Erden, Mn, Fe und/oder Al umfasst,
- die Elektroden (EL1, EL2) Cr, Ni, Ti, Al, Ag, Cu und/oder Au umfassen.

2. PTC-Heizer nach dem vorherigen Anspruch,
wobei gilt: L ≥ B > H.

3. PTC-Heizer nach einem der vorherigen Ansprüche, wobei der Grundkörper (GK) die Form eines Quaders, eines Zylinders, einer Folie oder eines Ellipsoids hat.

4. PTC-Heizer nach einem der vorherigen Ansprüche, wobei gilt:
2,5 cm ≤ L ≤ 5 cm,
1 cm ≤ B ≤ 4 cm und
100 µm ≤ H.

5. PTC-Heizer nach einem der vorherigen Ansprüche, ferner aufweisend einen Träger (TR), auf dem der Grundkörper (GK) angeordnet ist.

6. PTC-Heizer nach einem der vorherigen Ansprüche, wobei die dielektrische Schicht (IS) eine oxidische Keramik umfasst.

7. PTC-Heizer nach einem der vorherigen Ansprüche, ferner aufweisend einen Kühlkörper (KK), der mit dem Grundkörper (GK) verbunden ist und dazu vorgesehen ist, im Grundkörper (GK) dissipierte Wärme an die Umgebung abzugeben.

## Claims

1. PTC heater (HZ) with reduced inrush current, comprising
- a base body (GK) having a length L, a width B and a height H made of a PTC material,
- a first electrode (EL1) and a second electrode (EL2) made of an electrically conductive material,
a dielectric layer (IS) on a side surface of the base body (GK),
where
- L ≥ B ≥ H holds true for L, B and H, respectively,
- the electrodes (EL1, EL2) are attached to the base body (GK) in such a way that for their distance d from each other holds true:
d > H;
- the base body (GK) comprises doped BaTiO₃,
- the base body (GK) comprises Sr, Pb and/or Ca,
- the base body (GK) comprises a rare earth element, Mn, Fe and/or Al,
- the electrodes (EL1, EL2) comprise Cr, Ni, Ti, Al, Ag, Cu and/or Au.

2. PTC heater according to the previous claim,
wherein L ≥ B > H.

3. PTC heater according to any one of the preceding claims, wherein the base body (GK) has the shape of a cuboid, a cylinder, a foil or an ellipsoid.

4. PTC heater according to any one of the preceding claims, wherein:
2.5 cm ≤ L ≤ 5 cm,
1 cm ≤ B ≤ 4 cm, and
100 µm ≤ H.

5. PTC heater according to any one of the preceding claims, further comprising a support (TR) on which the base body (GK) is arranged.

6. PTC heater according to any one of the preceding claims, wherein the dielectric layer (IS) comprises an oxide ceramic.

7. PTC heater according to any one of the preceding claims, further comprising a heat sink (KK) connected to the base body (GK) and intended to dissipate heat dissipated in the base body (GK) to the environment.

## Revendications

1. Élément chauffant CTP (HZ) à courant d'appel réduit, comprenant
- un corps de base (GK) ayant une longueur L, une largeur B et une hauteur H en un matériau CTP,
- une première électrode (EL1) et une deuxième électrode (EL2) en un matériau électriquement conducteur, une couche diélectrique (IS) sur une surface latérale du corps de base (GK),
dans lequel
- pour L, B et H, on a : L ≥ B ≥ H,
- les électrodes (EL1, EL2) sont fixées au corps de base (GK) de telle sorte que leur distance l'une de l'autre d est telle que : d > H ;
- le corps de base (GK) comprend du BaTiO₃ dopé, et
- le corps de base (GK) comprend du Sr, du Pb et/ou du Ca, et
- le corps de base (GK) comprend un élément des terres rares, du Mn, du Fe et/ou de l'Al,
- les électrodes (EL1, EL2) comprennent du Cr, du Ni, du Ti, de l'Al, de l'Ag, du Cu et/ou de l'Au.

2. Élément chauffant CTP selon la revendication précédente, dans lequel on a L ≥ B > H.

3. Élément chauffant CTP selon l'une quelconque des revendications précédentes, dans lequel le corps de base (GK) a la forme d'un parallélépipède, d'un cylindre, d'une feuille ou d'un ellipsoïde.

4. Élément chauffant CTP selon l'une quelconque des revendications précédentes, dans lequel on a :
2,5 cm ≤ L ≤ 5 cm,
1 cm ≤ B ≤ 4 cm et
100 µm ≤ H.

5. Élément chauffant CTP selon l'une quelconque des revendications précédentes, comprenant en outre un support (TR), sur lequel est agencé le corps de base (GK) .

6. Élément chauffant CTP selon l'une quelconque des revendications précédentes, dans lequel la couche diélectrique (IS) comprend une céramique oxydique.

7. Élément chauffant CTP selon l'une quelconque des revendications précédentes, comprenant en outre un corps de refroidissement (KK), qui est relié au corps de base (GK) et qui est prévu pour émettre la chaleur dissipée dans le corps de base (GK) dans l'environnement.
